# FASCICULE DE BREVET EUROPEEN

(11) **EP 4 128 365 B1**
(45) Date de publication et mention de la délivrance du brevet: **08.05.2024**
(21) Numéro de dépôt: 21717155.2
(22) Date de dépôt: 23.03.2021
(51) Int. Cl.: H01L 31/0236, H01L 31/048, H02S 20/22, H02S 40/20

(54) **BIPV INTEGRANT UN ELEMENT TRANSPARENT OU TRANSLUCIDE A REFLEXION DIFFUSE**
BIPV MIT EINEM TRANSPARENTEN ODER DURCHSCHEINENDEN ELEMENT MIT DIFFUSER REFLEXION
BIPV COMPRISING A TRANSPARENT OR TRANSLUCENT ELEMENT WITH DIFFUSE REFLECTION

(30) Priorité: 24.03.2020 FR 2002860
(43) Date de publication de la demande: 08.02.2023
(73) Titulaire: Saint-Gobain Glass France, 92400 Courbevoie (FR)
(72) Inventeur: OZANAM, Cécile, 91120 PALAISEAU (FR); GAYOUT, Patrick, 93250 VILLEMOMBLE (FR); MILICEVIC, Marijana, 94250 GENTILLY (FR)
(74) Mandataire: Saint-Gobain Recherche
(86) Numéro de dépôt international: PCT/FR2021/050496
(87) Numéro de publication internationale: WO 2021/191557

(56) Documents cités:
- FR-A1- 2 991 064
- US-A1- 2017 033 250
- US-A1- 2019 081 588
- US-A1- 2019 386 607

## Description

La présente invention concerne une installation photovoltaïque adaptée pour être intégrée au bâtiment, pour montage en façade et/ou en toiture.

Rendre les bâtiments énergétiquement indépendants et réduire leur empreinte écologique est un des défis principaux de développement des villes et de la construction moderne. Les panneaux photovoltaïques (panneaux PV) représentent une source importante d'énergie renouvelable. Néanmoins, leur utilisation dans les bâtiments est souvent limitée en raison des difficultés rencontrées pour intégrer de tels panneaux PV dans les bâtiments, tant d'un point de vue esthétique que d'un point de vue structurel. Ainsi, l'apparence des cellules photovoltaïques classiques, donnée par la couleur bleue foncé de silicium et les contacts électriques en argent sur la surface, n'est pas considérée comme attractive pour les façades et les toitures de ville. Dans ce contexte, le photovoltaïque intégré aux bâtiments (acronyme anglais BIPV) comprend l'utilisation de solutions structurales, esthétiques et architecturales pour assurer une intégration harmonieuse de cellules photovoltaïques dans différents types de bâtiments.

Une piste explorée pour modifier drastiquement l'apparence d'un panneau photovoltaïque sans changer le milieu actif en silicium, consiste à modifier son élément de couverture, c'est-à-dire le système optique, souvent conçu en verre (coverglass en langue anglaise), qui est agencé au-dessus de la cellule photovoltaïque de sorte qu'il recouvre cette dernière, tel que vu depuis l'extérieur du bâtiment.

Selon une première technique, un motif ou une image sont imprimées sur le verre extérieur de l'élément de couverture, en utilisant une encre céramique ou un émail. Les avantages de cette technique sont le faible coût de conception et de production. Par contraste, l'inconvénient principal de cette technique est la perte importante de lumière en transmission. En effet, l'épaisseur typique de la couche ou du motif imprimé est comprise entre 15µm et 50µm, ce qui rend l'absorption de l'encre importante, de l'ordre de 24 à 34%, de même que la réflexion lumineuse, de l'ordre de 27 à 49%. Les niveaux de transmission lumineuses sont en conséquence relativement faibles. Afin de palier au moins partiellement ce problème, l'impression est généralement réalisée selon un pattern de points ou de lignes, afin de garder une partie de la surface complètement transparente. En dépit de ces efforts, la transmission lumineuse reste souvent insuffisante. De plus, l'effet esthétique lié à l'élément de couverture est dégradé, souvent de manière rédhibitoire, lorsque l'épaisseur de ce dernier est réduite. Enfin, une telle pratique a pour inconvénient d'occasionner une température non uniforme du panneau solaire, voire des points de sur-échauffement qui peuvent dégrader la fonctionnalité photovoltaïque.

Selon une deuxième technique, l'élément de couverture intègre un empilement de couches minces, c'est-à-dire un empilement de couches dont l'épaisseur est inférieure à 1 micromètre. Ces couches, du fait de leur faible épaisseur, absorbent moins de lumière que l'encre ou l'émail. Plus précisément, ces couches minces peuvent consister en des couches diélectriques dont l'épaisseur est comparable à la longueur d'onde de la lumière, de sorte que les effets d'interférence font que la couleur perçue est fortement affectée. Le choix des matériaux déposés et de leur épaisseur détermine la couleur en réflexion, qui peut donc peut être choisie. La technique permet d'obtenir des couleurs uniformes et saturées avec peu de pertes en transmission. Typiquement, les couches minces diminuent la transmission de 15% et l'efficacité de 5 à 10%. Le coût du développement et de production de ce type de produits reste cependant relativement élevé. Autre inconvénient, les effets d'interférences ont généralement une dépendance angulaire très forte. La couleur et la brillance peuvent donc varier selon l'angle d'observation, ce qui constitue un inconvénient majeur dans le contexte d'un montage en façade verticale.

Selon une troisième technique, des nanoparticules sont dispersées sur la surface ou dans le volume de l'élément de couverture. La taille de la nanoparticule détermine alors son interaction avec la lumière, en donnant une couleur définie. Du fait de la position aléatoire des nanoparticules, la réflexion est dite diffuse et ne peut pas être orientée selon une direction particulière.

De manière usuelle, la réflexion par un vitrage est dite diffuse lorsqu'un rayonnement incident sur le vitrage avec un angle d'incidence donné est réfléchi par le vitrage dans une pluralité de directions. La réflexion par un vitrage est dite spéculaire lorsqu'un rayonnement incident sur le vitrage avec un angle d'incidence donné est réfléchi par le vitrage avec un angle de réflexion égal à l'angle d'incidence.

La troisième technique permet de limiter les variations de l'apparence du vitrage en fonction de l'angle d'observation. Cette technique, bien que prometteuse, reste cependant complexe et onéreuse à mettre en œuvre,

Le document US2019/386607 A1 décrit une installation photovoltaïque adaptée pour être intégrée au bâtiment et comprenant un élément en couches.

La technique proposée permet de répondre aux inconvénients précédemment citées et se rapporte plus particulièrement, dans au moins un mode de réalisation particulier, à une installation photovoltaïque adaptée pour être intégrée au bâtiment, et comprenant au moins une cellule photovoltaïque en silicium, ladite installation photovoltaïque étant caractérisée en ce qu'elle comprend un élément en couches transparent ou translucide, comprenant au moins une couche externe inférieure, destinée à être orientée vers l'intérieur du bâtiment, et une couche externe supérieure, destinée à être orientée vers l'extérieur du bâtiment, lesdites couches extérieures formant chacune une surface principale externe de l'élément en couches et étant constituées en des matériaux diélectriques, ledit élément en couches comprenant en outre un ensemble laminaire intercalé entre les couches externes et formé d'au moins une couche intermédiaire, ladite couche intermédiaire étant soit une couche unique qui est une couche diélectrique d'indice de réfraction différent de celui des couches externes ou une couche métallique, soit un empilement de couches qui comprend au moins une couche diélectrique d'indice de réfraction différent de celui des couches externes ou une couche métallique, chaque surface de contact entre deux couches adjacentes de l'élément en couches qui sont l'une diélectrique et l'autre métallique, ou qui sont deux couches diélectriques d'indices de réfraction différents, étant texturée et préférentiellement parallèle aux autres surfaces de contact, ladite cellule photovoltaïque étant soit agencée en-dessous, soit intégrée dans ladite couche externe inférieure,
ladite couche externe inférieure (2) présentant un indice de réfraction (n2) compris entre l'indice de réfraction (n4) de la couche externe supérieure (4) et l'indice de réfraction (n7) de la cellule photovoltaïque (7), l'indice de la cellule photovoltaïque étant celui du silicium, et satisfaisant la formule : n2 ≥ n4 + (n7 - n4)/3

Dans le présent texte, l'élément en couches est dit transparent en ce qu'il donne lieu à une transmission spéculaire d'un rayonnement incident, au moins dans les domaines de longueurs d'onde utiles pour l'application visée de l'élément. A titre d'exemple, lorsque l'élément est utilisé en tant que vitrage de bâtiment ou de véhicule, il est transparent au moins dans le domaine de longueurs d'onde du visible. Par opposition, un vitrage translucide donne lieu à une transmission diffuse d'un rayonnement incident.

Au sens de l'invention, on entend par matériau ou couche diélectrique, un matériau ou une couche de conductivité électrique faible, inférieure à 100 S/m.

Dans le présent texte, un ensemble laminaire est d'une ou de plusieurs lames, dites également couches intermédiaires, déposées successivement sur la surface texturée de l'une des couches externes.

La surface de contact entre deux couches adjacentes est l'interface entre les deux couches adjacentes.

Une surface texturée est une surface pour laquelle les irrégularités de surface varient à une échelle plus grande que la longueur d'onde du rayonnement incident sur la surface. Le rayonnement incident est alors transmis et réfléchi de manière diffuse par la surface.

Le parallélisme des surfaces de contact texturées, en tant que caractéristique préférentielle, implique que la ou chaque couche constitutive de l'ensemble laminaire qui est diélectrique d'indice de réfraction différent de celui des couches externes, ou qui est métallique, présente une épaisseur uniforme perpendiculairement aux surfaces de contact de l'ensemble laminaire avec les couches externes. Cette uniformité de l'épaisseur peut être globale sur toute l'étendue de la texture, ou locale sur des tronçons de la texture. En particulier, lorsque la texture présente des variations de pente, l'épaisseur entre deux surfaces de contact texturées consécutives peut changer, par tronçon, en fonction de la pente de la texture, les surfaces de contact texturées restant toutefois toujours parallèles entre elles. Ce cas se présente notamment pour une couche déposée par pulvérisation cathodique, où l'épaisseur de la couche est d'autant plus faible que la pente de la texture augmente. Ainsi, localement, sur chaque tronçon de texture ayant une pente donnée, l'épaisseur de la couche reste constante, mais l'épaisseur de la couche est différente entre un premier tronçon de texture ayant une première pente et un deuxième tronçon de texture ayant une deuxième pente différente de la première pente.

Dans une installation photovoltaïque selon l'invention, l'élément en couches a fonction d'élément de couverture de la cellule photovoltaïque au-dessus de laquelle il est agencé, tel que vu depuis l'extérieur du bâtiment.

La mise en œuvre d'un tel élément en couches permet de camoufler efficacement la cellule photovoltaïque tout en conservant des performances satisfaisantes de transmission lumineuse.

En effet, et tel que décrit plus en détail dans la description, un tel élément en couches a pour double caractéristique technique de présenter à la fois une réflexion diffusante, et une transmission lumineuse effective, et donc satisfaisante.

De par cette réflexion diffuse, une partie des rayons solaires incidents est ainsi réfléchie de manière diffuse à la surface de l'ensemble laminaire, ce qui permet de limiter l'éblouissement et la génération de points chauds, tout en offrant un camouflage satisfaisant à la cellule photovoltaïque. L'élément en couches est de plus peu sensible aux variations colorimétriques liées à l'angle d'observation.

De par sa transmission effective, une partie significative des rayons incidents est réfractée et transmise à travers l'ensemble laminaire, ce qui permet de limiter les pertes énergétiques, et donc de maximiser l'exposition de la cellule photovoltaïque à travers l'élément en couches.

Ajouter à cela un effet de piégeage de lumière au niveau de la face interne de l'ensemble laminaire. Concrètement, après avoir traversé cet ensemble laminaire une première fois, une première partie des rayons lumineux est absorbée par la cellule photovoltaïque, tandis qu'une seconde partie est réfléchie vers ce même ensemble laminaire. Une sous-partie de cette lumière réfléchie est alors rétro-réfléchie par l'ensemble laminaire, vers la cellule photovoltaïque, ce qui permet d'améliorer plus encore son rendement énergétique. Compte tenu du fait que les cellules photovoltaïques sont opaques en transmission, aucun rayon lumineux n'est transmis depuis l'intérieur du bâtiment. Un observateur positionné du côté extérieur du bâtiment ne percevra donc que la réflexion diffuse sur l'ensemble laminaire, le pouvoir de réflexion devant seulement être suffisant pour camoufler la cellule photovoltaïque.

Selon l'invention, ladite couche externe inférieure présente un indice de réfaction (n2) compris entre l'indice de réfraction (n4) de la couche externe supérieure (4) et l'indice de réfraction (n7) de la cellule photovoltaïque (7), et satisfait préférentiellement la formule : n2 ≥ n4 + (n7 - n4)/3

Selon un exemple non couvert par les revendications mais utile pour comprendre l'invention, ladite couche externe inférieure présente sensiblement le même indice de réfraction (n2) que l'indice de réfraction (n4) de la couche externe supérieure (4).

Le terme « indice » fait référence à l'indice optique de réfraction, mesuré à la longueur d'onde de 550 nm. Au sens de l'invention, deux matériaux diélectriques ont sensiblement le même indice de réfraction, ou ont leurs indices de réfraction sensiblement égaux, lorsque la valeur absolue de la différence entre leurs indices de réfraction à 550 nm est inférieure ou égale à 0,15. De préférence, la valeur absolue de la différence d'indice de réfraction à 550 nm entre les matériaux constitutifs des deux couches externes de l'élément en couches est inférieure à 0,05, encore de préférence inférieure à 0,015. Par opposition, deux couches diélectriques ont des indices de réfraction différents lorsque la valeur absolue de la différence entre leurs indices de réfraction à 550 nm est strictement supérieure à 0,15.

Selon un mode de réalisation particulier, la mise en œuvre d'une couche externe inférieure d'indice intermédiaire entre celui de la couche externe supérieure et celui de la cellule photovoltaïque permet de limiter le phénomène de réflexion à l'interface entre ces deux derniers éléments, et ainsi d'accroître le rendement énergétique de l'installation photovoltaïque. Ces résultats techniques sont détaillés dans la description,

Selon un mode de réalisation particulier, ledit élément en couches présente, sur l'ensemble de la plage des longueurs d'onde comprise entre 300 nm et 1100 nm, une absorption lumineuse inférieure à 30%, préférentiellement inférieure 25%, préférentiellement inférieure 20% , préférentiellement inférieure 15% , préférentiellement inférieure 10%, préférentiellement inférieure à 5%, et/ou une réflexion inférieure à inférieure à 30%, préférentiellement inférieure 25%, préférentiellement inférieure 20%, préférentiellement inférieure 10%, et supérieure à 2,5%, préférentiellement supérieur à 5%.

La plage des longueurs d'onde comprise entre 300 nm et 1100 nm correspond à la plage d'absorption du silicium, composante essentielle des cellules photovoltaïques. Afin de maximiser l'apport énergétique à la cellule photovoltaïque, il est avantageux de limiter au maximum l'absorption dudit élément en couches dans cette plage de longueur d'onde. De même, il est avantageux de limiter son pouvoir de réflexion à une valeur minimale permettant de camoufler la cellule photovoltaïque depuis l'extérieur.

La mise en œuvre d'un tel ensemble laminaire permet donc de maximiser la quantité d'énergie transmise à la cellule photovoltaïque, et donc d'optimiser son rendement énergétique.

Selon un mode de réalisation particulier, ledit ensemble laminaire est formé d'une pluralité de couches intermédiaires et présente un réflexion au moins deux zones adjacentes dont les couleurs sont distinctes l'une de l'autre.

La notion de couleur regroupe les trois paramètres psychosensoriels mis en jeu dans l'établissement de son apparence visuelle, qui sont la luminosité, la teinte et la saturation, ces deux derniers paramètres pouvant être regroupés dans la notion de chromaticité. En faisant varier indépendamment les uns des autres ces trois paramètres, on peut réaliser toutes les sensations colorées imaginables. Dans ce contexte, les différents systèmes de description d'une couleur, par exemple les espaces colorimétriques de type CIE 1931 ou CIELAB 76 ou les types de coordonnées choisies dans chacun d'eux, ne sont que des façons différentes de définir les trois paramètres qui décrivent cette couleur. A des fins purement descriptives et non limitatives, les couleurs sont définies dans l'ensemble de la description selon l'espace CIELAB 76 (CIE 1976) avec comme source la lumière moyenne du jour (D65), et comme observateur standard l'observateur CIE 2° tel que défini par ses composantes trichromatiques spectrales représentant la réponse chromatique d'un observateur normalisé défini par la CIE en 1931, et en utilisant les coordonnées cartésiennes (L*, a*, b*) avec L* la clarté psychométrique (entre 0 et 100), a* la position chromatique sur un axe vert-rouge (entre -500 et 500), et b* la position chromatique sur un axe bleu-jaune (entre -200 et 200).

Dans le présent texte, deux couleurs sont dites distinctes lorsque le Delta E, calculé selon les espaces CIELAB 76 (CIE 1976), CIE94, CIEDE 2000 ou CMC 1 :c(1984), est compris entre 4,0 et 5,0, préférentiellement entre 2,0 et 4,0, encore préférentiellement entre 1,0 et 2,0. La couleur réfléchie par une zone spécifique de l'ensemble laminaire, considéré selon une vue de face par rapport à l'une des surfaces principales externes (2A, 4A), dépend de la nature des couches intermédiaires (31, 32,..., 3K) qui le composent, de l'épaisseur respective de ces dernières, de leur procédé de dépôt et/ou de leur ordre d'agencement. Ainsi, et tel que décrit plus en détail dans la description, si entre deux zones (A, B, C, D) de l'ensemble laminaire, au moins un de ces paramètres diffère, la probabilité est grande que ces deux zones (A, B, C, D) présenteront en réflexion des couleurs distinctes l'une de l'autre.

Ainsi, selon un mode de réalisation particulier non illustré, deux couches intermédiaires (31, 32,..., 3K) sont de même nature mais diffèrent de par leur épaisseur respective, ou leur procédé de dépôt. Du fait de ces différences, les zones couvertes respectivement par ces couches présenteront en réflexion des couleurs distinctes l'une de l'autre.

II est aujourd'hui connu de déterminer par simulation la couleur pouvant être obtenue en réflexion en faisant varier un ou plusieurs de ces paramètres, par exemple via les logiciels de modélisation ODE (WTheiss Hardware and Software), OptiLayer (Thin Films Software) ou Essential MacLeod (Thin Film Center). Cette caractéristique particulière permet donc à un Homme du Métier, en se fondant sur ses connaissances générales en modélisation d'empilements de couches, de produire un élément en couches faisant ressortir en réflexion un motif distinct. Ainsi, la simple réflexion de la lumière solaire sur la surface à réflexion diffuse de cet empilement de couches suffit à révéler un tel motif.

Selon un mode de réalisation particulier, au moins une couche intermédiaire est obtenue par pulvérisation cathodique assistée par champ magnétique (pulvérisation dite "cathodique magnétron") et/ou en ce qu'au moins une couche intermédiaire est obtenue par sérigraphie.

Selon un mode de réalisation particulier, au moins une couche intermédiaire (32), dite « couche motif », recouvre partiellement une autre couche intermédiaire (31), dite « couche de fond », la portion de recouvrement correspondante formant en réflexion une zone (C) de couleur distincte d'au moins une zone adjacente (B, D).

Dans le présent texte, la notion de « recouvrement » est considérée selon une vue de face par rapport à l'une des surfaces principales externes (2A, 4A) et n'implique donc aucun ordre d'agencement particulier, l'élément en couches pouvant être considéré depuis une de ses surfaces principales externes (2A, 4A), aussi bien que depuis l'autre. Les variations liées à un tel recouvrement sur l'épaisseur, la nature et/ou l'agencement des couches intermédiaires formant l'ensemble laminaire justifient l'obtention dans cette zone (C) de recouvrement d'une couleur distincte en réflexion d'au moins une zone adjacente (B, D).

Selon des modes de réalisations particuliers de l'invention, l'ensemble laminaire (3) peut comprendre une pluralité d'empilements successifs permettant l'obtention de différents motifs, de couleurs différentes.

Selon un mode de réalisation particulier, au moins une première couche intermédiaire (32) forme une inclusion traversante au sein d'une deuxième couche intermédiaire (31), et en ce que lesdites première et deuxième couches intermédiaires (31, 32) présentent en réflexion des couleurs distinctes l'une de l'autre.

En d'autres termes, la portion de la première couche intermédiaire (32), qui forme une inclusion traversante, correspond au négatif de la deuxième couche intermédiaire (31).

Selon un mode de réalisation particulier, la couche externe supérieure est destinée à être orientée vers l'extérieur du bâtiment, et comprend une surface externe texturée, dont la profondeur moyenne est préférentiellement supérieure 0,8 mm, préférentiellement supérieure 0,9 mm, préférentiellement supérieure 1,0 mm, préférentiellement supérieure 1,1 mm, préférentiellement supérieure 1,2 mm, et préférentiellement inférieure à 1,5 mm, préférentiellement inférieure à 1,3 mm.

La mise en œuvre d'une surface externe texturée, en comparaison avec une surface lisse, permet d'accroître la quantité de rayons solaire transmis à travers l'élément en couches. En particulier, de par la texturation de surface, on réduit significativement l'angle d'impact des rayons lumineux et donc les pertes en réflexion lumineuse qui y sont associées, ces dernières diminuant en même temps que cet angle d'impact. La texturation de surface confère donc un effet antireflet important. A cela s'ajoute de plus un effet additionnel de piégeage de lumière, détaillé dans la description. Sa mise en oeuvre contribue donc à améliorer le rendement de la cellule photovoltaïque.

Il a de plus été constaté que les performances augmentent avec la profondeur de la texture, indépendamment de l'angle d'incidence des rayons.

Selon un mode de réalisation particulier d'une installation selon l'nvention, préférentiellement pour montage en toiture, ladite surface externe texturée est à motif symétrique, par exemple de forme prismatique, préférentiellement de forme pyramidale inversée.

Au sens de l'invention, une texture à motif symétrique est composée de motifs géométriques en relief par rapport au plan général de ladite surface texturée, chaque motif présentant une symétrie par rapport à une droite ou à un plan théorique perpendiculaires audit plan général.

Tel que détaillé dans la description, une texture à motif symétrique permet d'accroître plus encore la quantité de rayons solaires transmis à travers l'élément en couches, en particulier dans le contexte d'une exposition à des rayons lumineux à faible angle d'incidence, tel que c'est le cas pour les montages en toiture. Cette amélioration est encore plus significative pour les motifs symétriques de forme pyramidale inversée.

Selon un mode de réalisation particulier, la texture de ladite surface externe est à motif symétrique de forme pyramidale inversée d'angle au sommet compris entre 80 et 100°, et/ou dont le plus petit cercle théorique pouvant contenir la base des motifs présente un diamètre compris entre 1,0 à 5,0 mm, préférentiellement entre 1,5 et 4,0 mm, préférentiellement entre 2,0 et 3,5 mm, préférentiellement entre 2,4 et 3,0 mm.

Tel que détaillé dans la description, dans le contexte d'un montage en toiture ou sur une surface inclinée d'une installation photovoltaïque selon l'invention, qui présente une texture de surface externe à motif symétrique de forme pyramidale inversée, le choix d'une telle valeur d'angle au sommet et/ou de telles valeurs de diamètre de cercle théorique permet d'accroître plus encore la quantité de rayons solaire transmis à travers l'élément en couches.

Selon un mode de réalisation particulier d'une installation photovoltaïque selon l'invention, préférentiellement pour montage en façade, ladite surface externe texturée est à motif asymétrique, par exemple de forme pyramidale inversée, préférentiellement de forme prismatique.

Par opposition à une texture à motif symétrique, une texture à motif asymétrique est composée de motifs géométriques en relief ne présentant pas de symétrie particulière par rapport à un quelconque plan perpendiculaire au plan général de texture. Ceci n'empêche cependant pas à ce même motif de se répéter régulièrement sur toute ou partie de la surface texturée.

Tel que détaillé dans la description, une texture à motif asymétrique permet d'accroître plus encore la quantité de rayons solaires transmis à travers l'élément en couches, en particulier dans le contexte d'une exposition à des rayons lumineux à grand angle d'incidence, tel que c'est le cas pour les montages en façade. Cette amélioration est encore plus significative pour les motifs symétriques de forme prismatique.

Selon un mode de réalisation particulier, la texture de ladite surface externe est à motif asymétrique qui présente un grand angle au sommet, compris entre 20° et 70°, préférentiellement entre 30° et 60°, préférentiellement entre 35° et 55°, préférentiellement entre 40° et 50°, préférentiellement entre 43° et 47°, et/ou qui présente un petit angle inférieur à 30°, préférentiellement inférieur à 25°, préférentiellement inférieur à 20°, préférentiellement inférieur à 15°, préférentiellement inférieur à 10°, préférentiellement inférieur à 5°.

Dans l'ensemble de la description, les valeurs de grand angle et de petit angle sont mesurées au sommet des motifs de texture, par rapport à la normale au plan général de texture.

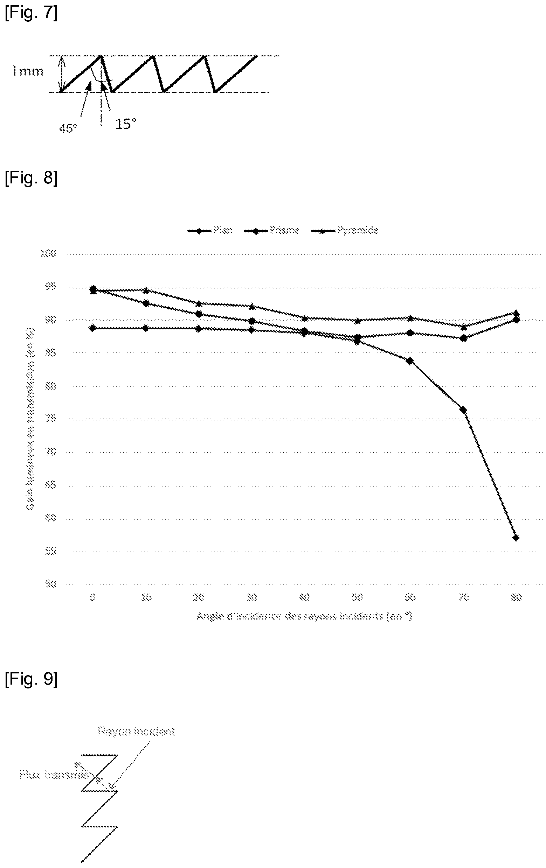

A titre d'exemple illustratif et non limitant, la Figure 7 est une représentation schématique en coupe d'un exemple de surface externe texturée à motif asymétrique. Dans cet exemple, la surface est agencée à l'horizontale et présente un motif de texture de forme prismatique, d'1 mm de profondeur, dont le sommet est la somme d'un petit angle de 15° et d'un grand angle de 45°.

Tel que détaillé dans la description, dans le contexte d'un montage en façade d'une installation photovoltaïque selon l'invention, qui présente une texture de surface externe à motif asymétrique de forme pyramidale inversée ou prismatique, l'adoption de telles valeurs de grand angle et/ou de petit angle permet d'accroître plus encore la quantité de rayons solaire transmis à travers l'élément en couches.

Selon un mode de réalisation particulier, une installation photovoltaïque selon l'invention comprend au moins une couche antireflet, à l'interface entre la surface de ladite cellule photovoltaïque destinée à être orientée vers l'extérieur du bâtiment et la couche externe inférieure, et/ou sur ladite surface externe de la couche externe supérieure.

Ce revêtement antireflet peut être de tout type permettant de réduire la réflexion de rayonnement à l'interface entre deux milieux optiques. Il peut ainsi être agencé à l'interface entre la surface de ladite cellule photovoltaïque destinée à être orientée vers l'extérieur du bâtiment et la couche externe inférieure.

De manière alternative, ou en combinaison, ce revêtement antireflet peut également être agencé sur la surface externe de la couche externe supérieure.

Lorsqu'il est agencé à l'interface entre un support sur lequel elle est déposée et l'air, un tel revêtement antireflet peut se présenter sous la forme d'une couche d'indice de réfraction compris entre l'indice de réfraction de l'air et l'indice de réfraction du support, telle qu'une couche déposée par une technique sous vide ou une couche poreuse de type sol-gel, ou encore, dans le cas où la couche externe est en verre, une partie superficielle creusée de la couche externe en verre obtenue par un traitement à l'acide de type « etching ». En variante, le revêtement antireflet peut être formé par un empilement de couches minces ayant des indices de réfraction alternativement plus faibles et plus forts jouant le rôle d'un filtre interférentiel à l'interface entre l'air et la couche externe, ou par un empilement de couches minces présentant un gradient, continu ou échelonné, d'indices de réfraction entre l'indice de réfraction de l'air et celui de la couche externe.

Lorsque le revêtement antireflet est agencé à l'interface entre la surface de ladite cellule photovoltaïque destinée à être orientée vers l'extérieur du bâtiment et la couche externe inférieure, il y a une diminution de la réflexion à cet endroit, et donc une augmentation de l'efficacité de collection de la lumière par la cellule photovoltaïque.

La présence d revêtement antireflet permet donc d'atténuer le phénomène de réflexion spéculaire au niveau d'une ou de plusieurs des surfaces externes du vitrage, sans pour autant réduire la réflexion diffuse au niveau de l'ensemble laminaire. De manière globale, une réflexion diffuse du rayonnement par l'élément en couches est ainsi favorisée par rapport à une réflexion spéculaire.

Selon un mode de réalisation particulier, l'invention concerne également le montage en bâtiment d'au moins une installation photovoltaïque (8) telle que celle décrite ci-dessus.

Selon un mode de réalisation particulier, ledit montage est mis en œuvre en toiture selon une orientation angulaire comprise entre 25 et 40°, préférentiellement entre 30 et 35° par rapport à l'horizontale, en direction du sud, préférentiellement au moyen d'une installation photovoltaïque (8) telle que celle décrite ci-dessus.

Tel que détaillé dans la description, une telle orientation permet d'accroître plus encore la quantité de rayons solaire transmis à travers l'élément en couches.

Selon un mode de réalisation particulier, ledit montage est mis en œuvre en façade, de préférence au niveau d'une allège, préférentiellement au moyen d'une installation photovoltaïque dont la surface externe texturée est à motif asymétrique, et est agencée de sorte que la face du motif asymétrique définie par ledit petit angle est sensiblement orientée vers le haut.

Tel que détaillé dans la description, une telle orientation permet de limiter les pertes en réflexion pouvant être liées à un piégeage défaillant des rayons incidents dans certaines conditions particulières d'éclairage.

Dans l'ensemble de la description, les allèges désignent les zones d'une façade vitrée se trouvant en dehors des zones dédiées à une vision en transparence (fenêtres, baies vitrées...), par exemple au niveau des éléments de structure (planchers, murs porteurs...).

L'invention concerne également un procédé de fabrication d'une installation photovoltaïque selon l'invention, qui comprend soit l'agencement de la cellule photovoltaïque en-dessous de l'élément en couches, soit son intégration au sein de la couche externe inférieure.

Ces agencements alternatifs de la cellule photovoltaïque permettent tous deux à cette dernière de bénéficier des effets bénéfiques liés à la mise en œuvre de l'élément en couches, et notamment de son ensemble laminaire.

L'invention concerne également l'utilisation d'une installation photovoltaïque selon l'invention, montée en bâtiment selon l'invention, pour la production d'énergie électrique.

Selon un mode de réalisation particulier, dans le présent texte, l'élément en couches peut être rigide ou flexible. Il peut s'agir en particulier d'un vitrage, constitué par exemple à base de verre ou de matériau polymère. Il peut s'agir également d'un film flexible à base de matériau polymère, notamment apte à être rapporté sur une surface afin de lui conférer des propriétés de réflexion diffuse tout en préservant ses propriétés de transmission.

Selon un mode de réalisation particulier, l'épaisseur de la couche externe inférieure est de préférence comprise entre 1 µm et 12 mm et varie selon le choix du matériau diélectrique.

Selon un mode de réalisation particulier, au moins une couche externe est un verre texture d'un seul côté et a une épaisseur comprise entre 0,4 et 10 mm, de préférence entre 0,7 et 4 mm.

Selon un mode de réalisation particulier, au moins une couche externe est en polymère texture d'un seul côté, par exemple un film plastique, et a une épaisseur comprise entre 0,020 et 2,000 mm, de préférence entre 0,025 et 0,500 mm.

Selon un mode de réalisation particulier, au moins une couche externe est constituée d'un intercalaire thermoplastique, préférentiellement du polyvinylbutyral (PVB), et a une épaisseur comprise entre 0,1 et 1,0 mm.

Selon un mode de réalisation particulier, au moins une couche externe est constituée d'une couche de matériaux diélectrique et a une épaisseur comprise entre 0,2 et 20 µm, de préférence entre 0,5 et 2 µm.

Selon un mode de réalisation particulier, au moins une couche externe comprend des matériaux durcissables initialement dans un état visqueux, liquide ou pâteux, qui sont adaptés à des opérations de mise en forme et ont une épaisseur comprise entre 0,5 et 100 µm, de préférence entre 0,5 et 40 µm, de préférence entre 0,5 et 15 µm.

Selon un mode de réalisation particulier, au moins une couche externe comprend des matériaux photoréticulables et/ou photopolymérisables qui ont une épaisseur comprise entre 0,5 et 20 µm, de préférence entre 0,7 et 10 µm.

Selon un mode de réalisation particulier, chaque couche externe de l'élément en couches est formée d'un empilement de sous-couches constituées en des matériaux ayant tous sensiblement le même indice optique. De manière alternative, l'interface entre ces sous-couches est soit lisse, soit texturée.

Le choix de l'épaisseur de l'ensemble laminaire dépend d'un certain nombre de paramètres. De manière générale, on considère que l'épaisseur totale de l'ensemble laminaire est comprise entre 5 et 200 nm et l'épaisseur d'une couche intermédiaire de l'ensemble laminaire est comprise entre 1 et 200 nm.

Selon un mode de réalisation particulier, l'ensemble laminaire est une couche métallique dont l'épaisseur est comprise entre 5 et 40 nm, préférentiellement entre 6 et 30 nm et encore préférentiellement entre 6 et 20 nm.

Selon un mode de réalisation particulier, l'ensemble laminaire est une couche diélectrique, par exemple de TiO2, et présente une épaisseur comprise entre 20 et 100 nm, et encore préférentiellement entre 45 et 75 nm et/ou un indice de réfraction compris entre 2,2 et 2,4.

Selon un mode de réalisation particulier, les couches de nature sol-gel sont déposées par un procédé de sérigraphie et ont une épaisseur avant recuit/à l'état liquide comprise entre 0,5 et 50 µm, de préférence entre 5 et 25 µm, de préférence entre 10 et 15 µm.

Selon le mode de réalisation particulier de l'invention, l'ensemble laminaire est déposé sur une portion seulement de la surface principale texturée de la couche externe inférieure. Les couches de fond et de motif ne sont donc apportées que sur cette portion de la couche externe inférieure.

Selon un mode de réalisation particulier, les surfaces principales externes de l'élément en couches et/ou les surfaces principales externes du vitrage sont planes ou bombées.

D'autres caractéristiques et avantages de l'invention apparaîtront à la lecture de la description suivante de modes de réalisation particuliers, donnés à titre de simples exemples illustratifs et non limitatifs, et des figures annexées, pour lesquelles :
[Fig. 1] la figure 1 est une coupe transversale schématique d'un élément en couches ;
[Fig. 2] la figure 2 est une vue à plus grande échelle du détail l de la figure 1 pour une première variante de l'élément en couches ;
[Fig. 3] la figure 3 est une vue à plus grande échelle du détail l de la figure 1 pour une deuxième variante de l'élément en couches ; et
[Fig. 4] [Fig. 5] les figures 4 et 5 sont deux coupes transversales schématiques d'une installation photovoltaïque adaptée pour être intégrée au bâtiment selon deux modes de réalisation alternatifs de l'invention ;
[Fig. 6] la figure 6 est une vue en perspective d'une surface texturée à motif symétrique, en forme de pyramide inversée ;
[Fig. 7] la figure 7 est une représentation schématique en coupe d'une texturation à motif asymétrique, en forme de prisme,
[Fig. 8] la figure 8 est une représentation graphique de la variation du gain d'une installation photovoltaïque en fonction de l'angle d'incidence de la lumière et de la texturation de surface,
[Fig. 9] [Fig. 10] les figures 9 et 10 sont des vues schématiques en coupe transversale illustrant la propagation de rayons lumineux à l'interface entre l'air et une surface verrière ayant une texture asymétrique, selon deux configurations alternatives ;

Les différents éléments illustrés par les figures ne sont pas nécessairement représentés à l'échelle réelle, l'accent étant davantage porté sur la représentation du fonctionnement général de l'invention. Sur les différentes figures, sauf indication contraire, les numéros de référence qui sont identiques représentent des éléments similaires ou identiques.

Plusieurs modes de réalisation particuliers de l'invention sont présentés par la suite. Il est entendu que la présente invention n'est nullement limitée par ces modes de réalisation particuliers et que d'autres modes de réalisation peuvent parfaitement être mis en oeuvre.

Notons de plus que dans toute la description, l'expression « compris(e) entre ... et ... » inclut les bornes dans l'intervalle.

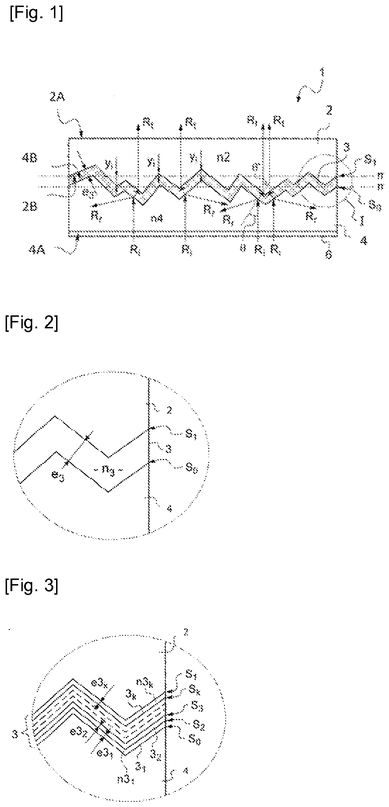

Les Figures 1 à 3 représentent un élément en couches transparent adapté pour être mis en œuvre au sein d'une installation photovoltaïque, et visent à en illustrer le fonctionnement général. Pour la clarté du dessin, les épaisseurs relatives des différentes couches n'ont pas été rigoureusement respectées. De plus, la possible variation d'épaisseur de chaque couche constitutive de l'ensemble laminaire en fonction de la pente de la texture n'a pas été représentée sur les figures, étant entendu que cette possible variation d'épaisseur n'impacte pas le parallélisme des surfaces de contact texturées. En effet, pour chaque pente donnée de la texture, les surfaces de contact texturées sont parallèles entre elles.

Dans toute la description l'élément en couches transparent est considéré posé horizontalement, avec sa première face orientée vers le bas définissant une surface principale externe inférieure, destinée à être agencée en vis-à-vis ou du moins à proximité de la cellule photovoltaïque, et sa seconde face, opposée à la première face, orientée vers le haut définissant une surface principale externe supérieure, destinée à être positionnée vers l'extérieur du bâtiment ; les sens des expressions "au-dessus" et "en-dessous" sont ainsi à considérer par rapport à cette orientation. A défaut de stipulation spécifique, les expressions "au-dessus" et "en-dessous" ne signifient pas nécessairement que les deux couches sont disposées au contact l'une de l'autre. Les termes "inférieur" et "supérieur" sont utilisés ici en référence à ce positionnement.

L'élément en couches 1 représenté sur la Figure 1 correspond à un exemple non couvert par les revendications mais utile pour comprendre l'invention, et comprend deux couches externes 2 et 4, qui sont constituées en des matériaux diélectriques transparents ayant sensiblement le même indice de réfraction n2, n4.

Dans un mode de réalisation selon l'invention, non représenté, la couche externe inférieure 2 présente un indice de réfraction intermédiaire entre celui de la couche externe supérieure 4 et celui de la cellule photovoltaïque 7, ce qui permet de limiter le phénomène de réflexion à l'interface entre ces deux derniers éléments, et ainsi d'accroître le rendement énergétique de l'installation photovoltaïque 8. Compte tenu de la différence d'indice de réfraction existante entre les couches externes 2 et 4, les rayons réfractés dans la couche externe inférieure 2 sont déviées de leur trajectoire au sein de la couche externe supérieure 4. La transmission au sein de l'élément en couche 1 est donc diffuse, rendant ce dernier translucide.

Chaque couche externe 2 ou 4 présente une surface principale externe, respectivement 2A ou 4A, dirigée vers l'extérieur de l'élément en couches, et une surface principale texturée, respectivement 2B ou 4B, dirigée vers l'intérieur de l'élément en couches.

Les textures des surfaces internes 2B et 48 sont complémentaires l'une de l'autre. Comme illustré sur la Figure 1, les surfaces texturées 2B et 48 sont positionnées en regard l'une de l'autre, dans une configuration où leurs textures sont strictement parallèles entre elles. L'élément en couches 1 comprend également un ensemble laminaire 3, intercalée en contact entre les surfaces texturées 2B et 4B.

Dans la variante montrée sur la Figure 2, l'ensemble laminaire 3 est monocouche et constituée en un matériau transparent qui est soit métallique, soit diélectrique d'indice de réfraction n3 différent de celui des couches externes 2 et 4. Dans la variante montrée sur la figure 3, l'ensemble laminaire 3 est formée d'une unique couche intermédiaire, elle-même formée d'un empilement transparent de plusieurs couches 31, 32, ..., 3k, où au moins l'une des couches 31 à 3k est soit une couche métallique, soit une couche diélectrique d'indice de réfraction différent de celui des couches externes 2 et 4. De préférence, au moins chacune des deux couches 31 et 3k situées aux extrémités de l'empilement est une couche métallique ou une couche diélectrique d'indice de réfraction n31 ou n3k différents de celui des couches externes 2 et 4.

Sur les Figures 1 à 3, on note S0 la surface de contact entre la couche externe 2 et l'ensemble laminaire 3, et S1 la surface de contact entre l'ensemble laminaire 3 et la couche externe 4. De plus, sur la figure 3, on note successivement S2 à Sk les surfaces de contact internes de l'ensemble laminaire 3, en partant de la surface de contact la plus proche de la surface S0.

Dans la variante de la Figure 2, du fait de l'agencement de l'ensemble laminaire 3 en contact entre les surfaces texturées 2B et 4B qui sont parallèles entre elles, la surface de contact S0 entre la couche externe 2 et l'ensemble laminaire 3 est texturée et parallèle à la surface de contact S1 entre l'ensemble laminaire 3 et la couche externe 4. En d'autres termes, l'ensemble laminaire 3 est une couche texturée présentant, au moins localement, une épaisseur e3 uniforme, prise perpendiculairement aux surfaces de contact S0 et S1.

Dans la variante de la Figure 3, chaque surface de contact S2, ..., Sk entre deux couches adjacentes de l'empilement constitutif de l'ensemble laminaire 3 est texturée et strictement parallèle aux surfaces de contact S0 et S1 entre les couches externes 2, 4 et l'ensemble laminaire 3. Ainsi, toutes les surfaces de contact S0, S1, ..., Sk entre des couches adjacentes de l'élément 1 qui sont soit de natures différentes, diélectrique ou métallique, soit diélectriques d'indices de réfraction différents, sont texturées et parallèles entre elles. En particulier, chaque couche 31, 32, ..., 3k de l'empilement constitutif de l'ensemble laminaire 3 présente, au moins localement, une épaisseur e31, e32, ..., e3k uniforme, prise perpendiculairement aux surfaces de contact S0, S1, ..., Sk.

Comme montré sur la Figure 1, la texture de chaque surface de contact S0, S1 ou S0, S1, ..., Sk de l'élément en couches 1 est formée par une pluralité de motifs en creux ou en saillie par rapport à un plan général π de la surface de contact.

La Figure 1 illustre le parcours d'une pluralité de rayons de lumière qui sont incidents sur l'élément en couches 1 du côté de la couche externe 2. A noter que dans les cas particuliers illustrés aux Figures 1, 4 et 5, auxquelles l'invention ne se limite pas, les surfaces externes des couches externes 2 et 4 sont lisses, ce qui permet aux rayons incidents orientés selon la normale à ces surfaces de ne pas être déviés au moment de passer du milieu d'incidence au milieu de réfraction. Selon des modes de réalisations alternatifs de l'invention, dont certains sont décrits dans la suite de la description, l'une au moins des surfaces externes 2A et 4A est texturée, ce qui donne lieu à une diffusion de la lumière en réflexion et en transmission.

Sur la Figure 1, les rayons incidents Ri arrivent perpendiculairement à la couche externe supérieure 4 (cette dernière étant arbitrairement positionnée vers le bas sur les figures 1 à 3. Les rayons incidents Ri, lorsqu'ils atteignent la surface de contact S0 entre la couche externe 4 et l'ensemble laminaire 3, avec un angle d'incidence θ donné, sont réfléchis soit par la surface métallique, soit du fait de la différence d'indice de réfraction à cette surface de contact respectivement entre la couche externe 4 et l'ensemble laminaire 3 dans la variante de la figure 2 et entre la couche externe 4 et la couche 31 dans la variante de la figure 3. Comme la surface de contact S0 est texturée, la réflexion s'opère dans une pluralité de directions Rr. La réflexion du rayonnement par l'élément en couches 1 est donc diffuse.

Une partie du rayonnement incident est également réfractée dans l'ensemble laminaire 3. Dans la variante de la figure 2, les surfaces de contact S0 et S1 sont parallèles entre elles, ce qui implique d'après la loi de Snell-Descartes que n2.sin(θ) = n4.sin(θ'), où θ est l'angle d'incidence du rayonnement sur l'ensemble laminaire 3 à partir de la couche externe 4 et θ' est l'angle de réfraction du rayonnement dans la couche externe inférieure 2 à partir de l'ensemble laminaire 3. Dans la variante de la figure 3, comme les surfaces de contact S0, S1, ..., Sk sont toutes parallèles entre elles, la relation n2.sin(θ) = n4.sin(θ') issue de la loi de Snell-Descartes reste vérifiée. Dès lors, dans les deux variantes, comme les indices de réfraction n2 et n4 des deux couches externes sont sensiblement égaux l'un à l'autre, les rayons Rt transmis par l'élément en couches sont transmis avec un angle de transmission θ' égal à leur angle d'incidence θ sur l'élément en couches. La transmission du rayonnement par l'élément en couches 1 est donc spéculaire.

Dans un mode de réalisation selon l'invention, non représenté, la couche externe inférieure 2 présente un indice de réfraction intermédiaire entre celui de la couche externe supérieure 4 et celui de la cellule photovoltaïque 7, ce qui permet de limiter le phénomène de réflexion à l'interface entre ces deux derniers éléments, et ainsi d'accroître le rendement énergétique de l'installation photovoltaïque 8. Compte tenu de la différence d'indice de réfraction existante entre les couches externes 2 et 4, les rayons réfractés dans la couche externe inférieure 2 sont déviées par rapport à leur trajectoire au sein de la couche externe supérieure 4. La transmission au sein de l'élément en couche 1 est donc diffuse, rendant ce dernier translucide.

Des exemples de substrats en verre directement utilisables en tant que couche externe de l'élément en couches, comprennent :
- les substrats en verre commercialisés par la société Saint-Gobain Glass dans la gamme SATINOVO^{®}, qui sont déjà textures et présentent sur l'une de leurs surfaces principales une texture obtenue par sablage ou attaque acide ;
- les substrats en verre commercialisés par la société Saint-Gobain Glass dans la gamme ALBARINO^{®} S, P ou G ou dans la gamme MASTERGLASS^{®}, qui présentent sur l'une de leurs surfaces principales une texture obtenue par laminage,
- les substrats en verre à haut indice textures par sablage tel que du verre flint par exemple commercialisés par la société Schott sous les références SF6 (n=1 ,81), 7SF57 (n=1 ,85), N-SF66 (n=1 ,92), P-SF68 (n=2,00).

Des exemples de polymères appropriés pour le substrat transparent comprennent les polyesters tels que le polyéthylène téréphtalate (PET), le polybutylène téréphtalate (PBT), le polyéthylène naphtalate (PEN) ; les polyacrylates tels que le polyméthacrylate de méthyle (PMMA) ; le polycarbonate ; le polyuréthane ; les polyamides ; les polyimides ; les polymères fluorés tels que l'éthylène tétrafluoroéthylène (ETFE), le polyfluorure de vinylidène (PVDF), le polychlorotrifluoréthylène (PCTFE), l'éthylène de chlorotrifluoréthylène (ECTFE), les copolymères éthylène-propylène fluorés (FEP) ; les résines photoréticulables et/ou photopolymérisables, telles que les résines thiolène, polyuréthane, uréthane-acrylate, polyester-acrylate.

Des exemples de couches centrales pouvant être intercalées entre les couches externes comprennent les couches minces diélectriques, choisi parmi les oxydes, nitrures ou halogénures d'un ou plusieurs métaux de transition, non-métaux ou métaux alcalino-terreux, notamment des couches de Si3N4, SnO2, ZnO, ZrO2, SnZnOx, AlN, NbO, NbN, TiO2, SiO2, AI2O3, MgF2, AlF3, ou de couches minces métalliques, notamment des couches d'argent, d'or, de cuivre, de titane, de niobium, de silicium, d'aluminium, d'alliage nickel-chrome (NiCr), d'acier inoxydable, ou d'alliages de ces métaux.

La texturation de l'une des surfaces principales des couches externes peut être obtenue par tout procédé connu de texturation, par exemple par embossage de la surface du substrat préalablement chauffée à une température à laquelle il est possible de la déformer, en particulier par laminage au moyen d'un rouleau ayant à sa surface une texturation complémentaire de la texturation à former sur le substrat ; par abrasion au moyen de particules ou de surfaces abrasives, en particulier par sablage ; par traitement chimique, notamment traitement à l'acide dans le cas d'un substrat en verre ; par moulage, notamment moulage par injection dans le cas d'un substrat en polymère thermoplastique ; par gravure.

Les motifs de la texture de chaque surface de contact entre deux couches adjacentes de l'élément en couches qui sont l'une diélectrique et l'autre métallique, ou qui sont deux couches diélectriques d'indices de réfraction différents, peuvent être répartis de manière aléatoire sur la surface de contact. En variante, les motifs de la texture de chaque surface de contact entre deux couches adjacentes de l'élément en couches qui sont l'une diélectrique et l'autre métallique, ou qui sont deux couches diélectriques d'indices de réfraction différents, peuvent être répartis de manière périodique sur la surface de contact. Ces motifs peuvent être, notamment, des cônes, des pyramides, des rainures, des nervures, des vaguelettes.

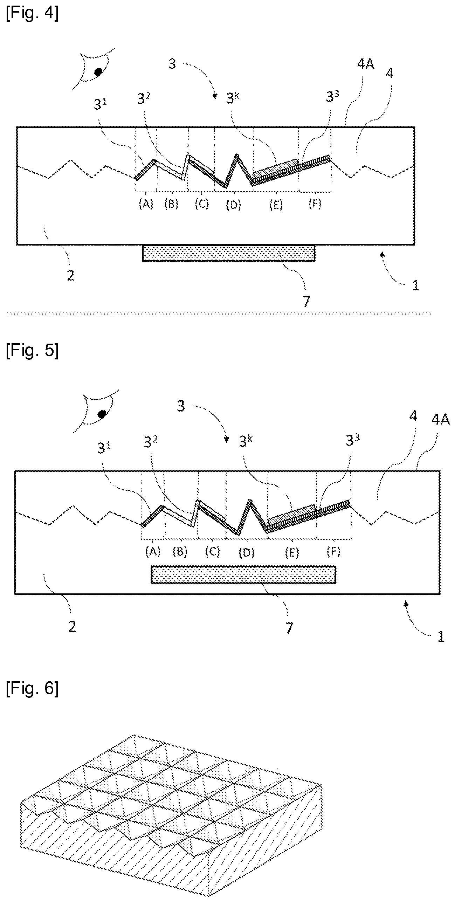

Les figures 4 et 5 illustrent un élément en couches 1 selon mode de réalisation particulier de l'invention, qui comprend un ensemble laminaire 3 intercalé entre les couches externes (2, 4) et formé de 4 (quatre) couches intermédiaires (31, 32, 32 et 3K), chaque couche intermédiaire étant dans le cas d'espèce une couche unique diélectrique d'indice de réfraction différent de celui des couches externes, les surfaces de contact des couches intermédiaires (31, 32, 32 et 3K) et des couches externes (2, 4) étant toutes texturées et parallèles entre elles afin de présenter des propriétés satisfaisantes de transparence et de réflexion diffuse.

Plus précisément, l'ensemble laminaire 3 représenté en coupe par les figures 4 et 5 est divisé en 6 (six) zones (A, ..., F), chaque zone présentant en réflexion une couleur distincte de celle des zones adjacentes.

Ainsi, dans les zones A, B et D, les caractéristiques colorimétriques de l'ensemble laminaire 3 en réflexion sont dictées par la nature et l'épaisseur des couches intermédiaires 31 et 32. Notons à ce propos que les zones A et D présentent en réflexion la même couleur, bien que ces deux zones ne soient pas adjacentes. La zone C est une portion de recouvrement des couches intermédiaires 31 et 32. Compte tenu de son épaisseur totale, et de l'agencement particulier de ces couches, cette zone B présente en réflexion une couleur distincte de celle des zones adjacentes B et D. A noter de plus que cette zone C présente une couleur différente en réflexion selon qu'elle soit observée depuis le dessus l'élément en couche 1, ou depuis le dessous. De même, la zone F est caractérisée par le recouvrement des couches intermédiaires 31 et 33, et la zone E est caractérisée par le recouvrement des couches 31, 33 et 3k.

Selon un mode de réalisation alternatif, non illustré, les 4 (quatre) couches intermédiaires (31, 32, 32 et 3K) sont toutes de même nature. Si les épaisseurs diffèrent d'une couche intermédiaire (31, 32, 32 et 3K) à une autre, chaque zone présente en conséquence une couleur différente en réflexion. En revanche, si les épaisseurs des couches intermédiaires sont identiques, on obtient une première couleur dans les zones A, B et D, une deuxième couleur dans les zones B et F, et une troisième couleur dans la zone E.Selon les modes de réalisation particuliers illustrés par les figure 4 et 5, l'ensemble laminaire 3 est déposé sur une portion seulement de la surface principale texturée de la couche externe inférieure 2. Les couches de fond et de motif ne sont donc apportées que sur cette portion de la couche externe inférieure. Dans les zones non recouvertes par cet ensemble laminaire, le ratio de transmission lumineuse est augmenté. De manière générale, l'élément en couche présente donc une transmittance plus élevée.

Selon un mode de réalisation alternatif, non représenté, l'ensemble laminaire 3 est déposé sur la totalité de la surface principale texturée de la couche externe inférieure 2.

Selon un mode de réalisation particulier, deux passes de dépôts sont réalisées par magnétron. Un masque est alors introduit dans l'enceinte de dépôt pour au moins un des 2 (deux) dépôts.

Selon un mode de réalisation alternatif, au moins une passe de dépôt est réalisée par sérigraphie et comprend le positionnement d'un écran de sérigraphie en regard de la surface principale texturée 2B de la couche externe inférieure 2, et le dépôt sur l'écran de sérigraphie et son transfert sur le substrat, à l'aide d'une racle, d'une couche diélectrique d'indice de réfraction n3 différent de celui des couches externes ou d'une couche métallique.

Les modes de réalisation alternatifs illustrés respectivement par les Figures 4 et 5 se distinguent l'un de l'autre par l'agencement de la cellule photovoltaïque, soit en-dessous de l'élément en couches (Figure 4), soit au sein de la couche externe inférieure 2 (Figure 5).

Dans les deux cas, la cellule photovoltaïque bénéficie des effets techniques liés à la mise en œuvre de l'élément en couches, et notamment de son ensemble laminaire. Ainsi, les rayons lumineux frappant la surface externe 4A de l'installation ne sont que partiellement réfléchis et/ou absorbés lors de leur passage au travers de cette surface externe 4A, en particulier si cette dernière est texturée, et de l'ensemble laminaire 3.

De par la réflexion diffuse, une partie des rayons solaires incidents est ainsi réfléchie de manière diffuse à la surface de l'ensemble laminaire 3, ce qui permet de limiter l'éblouissement et la génération de points chauds, tout en offrant un camouflage satisfaisant à la cellule photovoltaïque 7. L'élément en couches 1 est de plus peu sensible aux variations colorimétriques liées à l'angle d'observation.

De par sa transmission spéculaire, une autre partie des rayons incidents est réfractée et transmise à travers l'ensemble laminaire 3 de manière spéculaire, ce qui permet de limiter les pertes énergétiques, et donc de maximiser l'exposition de la cellule photovoltaïque 7 à travers l'élément en couches 1.

La mise en œuvre d'un tel élément en couches 1 permet donc de camoufler efficacement la cellule photovoltaïque 7 tout en conservant des performances satisfaisantes de transmission lumineuse.

Ajouter à cela un effet de piégeage de lumière au niveau de la face interne de l'ensemble laminaire 3. Concrètement, après avoir traversé cet ensemble laminaire 3 une première fois, une première partie des rayons incidents est absorbée par la cellule photovoltaïque 7, tandis qu'une seconde partie est réfléchie vers ce même ensemble laminaire 3. Une sous-partie de cette lumière réfléchie est alors rétro-réfléchie par l'ensemble laminaire 3, vers la cellule photovoltaïque 7, ce qui permet d'améliorer plus encore son rendement énergétique.

Afin d'évaluer le rôle joué par la valeur d'indice optique de la couche externe inférieure 2 sur l'amélioration des performances de la cellule photovoltaïque, un premier essai est simulé informatiquement pour une installation photovoltaïque 8 selon l'invention, qui comprend une cellule photovoltaïque 7 classique, dont l'indice optique est de l'ordre de 4,00.

Pour un premier échantillon, une cellule photovoltaïque est associée à un élément en couche de référence, non couvert par l'invention, qui correspond à la superposition de deux couches (externes) d'indices optiques (n2, n4) de 1,4812, qui peuvent être composée de verre clair ou extra-clair, par exemple un verre de type SGG Planiclear, d'une épaisseur de 4 mm, et dont l'ensemble des surfaces sont lisses. Un tel élément en couche ne présente pas d'ensemble laminaire 3,

Un deuxième échantillon se distingue du premier échantillon en ce qu'il comprend en plus un ensemble laminaire 3, formé d'une unique couche d'oxyde de titane (TiO2) de 60 nm d'épaisseur,

Un troisième et un quatrième échantillon comprennent tous deux un élément en couches 3 qui présente l'empilement suivant :
- une couche externe inférieure 2 dont l'indice optique n2 varie entre le troisième et le quatrième échantillon, tel que décrit plus en détail dans la suite de la description. Une telle couche externe inférieure 2 peut être composée de verre clair ou extra-clair au moins en partie texture, d'une épaisseur de 4 mm, ayant au niveau de sa surface interne texturée une hauteur pics/vallée (Rz) environ égale 10,6 µm,
- un ensemble laminaire 3 formé d'une unique couche d'oxyde de titane (TiO2) de 60 nm d'épaisseur,
- une couche externe supérieure 4, d'indice optique n4 égal à 1,4812, qui peut être composée de verre clair ou extra-clair, par exemple un verre de type SGG Satinovo, au moins en partie texture sur sa surface interne 4B, et qui comprend une surface externe 4A lisse.

Dans le troisième échantillon, l'indice optique n2 de la couche externe inférieure 2 est de 1,4812, et est donc égal à l'indice optique n4 de la couche externe supérieure 4.

Pour le quatrième échantillon, l'indice optique n2 de la couche externe inférieure 2 est de 3,00 et correspond donc à une valeur médiane entre l'indice n4 de la couche externe supérieure 4 et l'indice n7 de la cellule photovoltaïque 7.

Pour ce premier essai, les estimations faites portent sur le flux lumineux transmis à la cellule photovoltaïque, rapporté au flux incident pour des rayons dont l'angle d'incidence est alternativement de 0°, 45° à 80° par rapport à la normale au plan général de texture, qui correspond au plan théorique de l'élément en couche. En d'autres termes, l'objet des mesures effectuées est le gain lumineux en transmission lié à la mise en œuvre de tel ou tel élément en couches, en fonction entre autres de l'angle des rayons incidents. Les résultats sont exprimés en pourcentage (%) dans le tableau 1 ci-dessous.

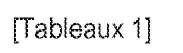

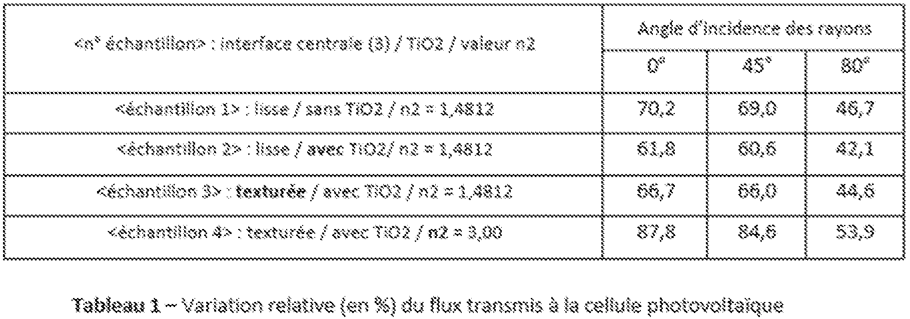

Les estimations obtenues permettent d'aboutir à plusieurs conclusions :
- La proportion de flux transmis à la cellule photovoltaïque diminue lorsque l'angle d'incidence augmente.
- L'agencement de deux couches externes lisses devant la cellule photovoltaïque, indépendamment de la présence d'une couche centrale de TiO2 lisse ou texturée (voir échantillon 1), engendre une perte en transmission de 29,8 à 53,3%. Cette perte en transmission est majoritairement liée à la réflexion lumineuse à l'interface entre la couche externe inférieure et la cellule photovoltaïque.
- L'ajout d'une couche centrale de TiO2 n'engendre qu'une perte relativement faible en transmission, en témoigne la comparaison des résultats obtenus respectivement pour les échantillons 1 et 2. Ces pertes sont liées à la réflexion spéculaire au niveau de la couche centrale de TiO2, cette dernière étant lisse,
- La texturation de la couche centrale de TiO2 permet d'accroître la transmission lumineuse, en témoigne la comparaison des résultats obtenus respectivement pour les échantillons 2 et 3. Ces pertes sont liées à la réflexion diffuse au niveau de la couche centrale de TiO2 (texturée), et de la baisse de l'angle d'impact des rayons incidents, ce qui permet d'accroître la proportion de rayons réfractés,
- L'adoption pour la couche externe inférieure 2 d'une valeur médiane d'indice optique n2 permet d'accroître significativement la proportion du flux incident transmis à la cellule photovoltaïque 7, en témoigne la comparaison des résultats obtenus respectivement pour les échantillons 3 et 4.

Afin de de mettre en évidence d'autres avantages techniques conférés par l'invention revendiquée, une série d'essais supplémentaires est réalisée sur une installation photovoltaïque 8 selon l'invention, qui comprend une cellule photovoltaïque classique agencée en-dessous d'un élément en couches 1 présentant l'empilement suivant :
- une couche externe inférieure 2 : substrat en verre clair ou extra-clair au moins en partie texture, par exemple un verre de type SGG Satinovo commercialisé par Saint-Gobain Glass, d'une épaisseur de 4 mm, ayant au niveau de sa surface interne texturée une hauteur pics/vallée (Rz) environ égale 10,6 µm, mesurée avec filtre passe bande 15-800 microns (ET 0.9 - mini 8 - maxi 13.4 pour une surface mesurée de 2×2 mm²).
- un ensemble laminaire 3 déposé exclusivement par magnétron, et formé de l'empilement d'une première couche d'oxyde de titane (TiO2) de 65 nm, d'une couche de nitrure de silicium (SiN) de 55 nm, et d'une deuxième couche d'oxyde de titane (TiO2) de 385 nm d'épaisseur,
- une couche externe supérieure 4 : substrat en verre clair ou extra-clair, par exemple un verre de type SGG Satinovo, au moins en partie texture sur sa surface interne 4B, et qui comprend une surface externe 4A, destinée à être agencée vers l'extérieur du bâtiment, et dont la texture de surface varie en fonction des échantillons étudiés, tel que décrit plus en détail dans la suite de la description.

Dans cette série d'essais, la cellule photovoltaïque 7 est séparée de l'élément en couches 3 par une couche antireflet de nitrure de silicium (Si3N4) de 75 nm d'épaisseur, non représentée sur les figures. L'indice de cette couche antireflet est de l'ordre de 1,85 compris entre celui du verre (environ 1,52) et celui du silicium (environ 4,00). L'effet antireflet est obtenu grâce à ce gradient d'indice.

Selon un mode de réalisation alternatif non représenté, un revêtement antireflet à fonction similaire est agencé sur la surface externe 4A de la couche externe supérieure 4, dans l'objectif de réduire les réflexions occasionnées au niveau de cette interface de l'élément en couches 1 avec l'air.

Un deuxième essai est réalisé avec d'une part, une installation photovoltaïque selon l'invention ayant une surface externe 4A non texturée, c'est-à-dire lisse, et d'autre part sur une installation photovoltaïque qui ne présente pas d'ensemble laminaire 3 (non couverte par l'invention). Les deux installations sont mises à l'essai à Paris, en position verticale et dirigée vers le sud, pendant une durée d'exposition d'une année.

Ce deuxième essai permet d'établir que la perte annuelle d'énergie générée par la cellule photovoltaïque 7 est de seulement 5,2% dans le cadre d'une installation photovoltaïque équipée d'un ensemble laminaire 3, en comparaison avec une installation qui en est dépourvue.

Les pertes énergiques liées à la mise en œuvre d'une installation photovoltaïque selon l'invention sont donc relativement faibles, au regard des possibilités offertes en terme de camouflage de la cellule photovoltaïque depuis l'extérieur du bâtiment.

Afin d'évaluer les effets d'une texturation à motif symétrique de la surface externe 4A sur les performances de la cellule photovoltaïque, un troisième essai est réalisé au moyen des trois échantillons suivants :
Un premier échantillon ayant une surface externe 4A lisse,
Un deuxième échantillon ayant une surface externe 4A texturée à motif symétrique de forme prismatique de période 2 mm et d'angle au sommet d'environ 90°.

Un troisième échantillon ayant une surface externe 4A texturée à motif symétrique de forme pyramidale inversée à base carrée, de période 2 mm et d'angle au sommet d'environ 90°. Une telle texture est notamment illustrée schématiquement par la figure 6.

Pour ce troisième essai, les mesures portent sur le flux lumineux transmis à la cellule photovoltaïque, rapporté au flux incident pour des rayons dont l'angle d'incidence varie de 0 à 80° par rapport à la normale au plan général de texture, qui correspond au plan théorique de l'élément en couche. En d'autres termes, l'objet des mesures effectuées est le gain lumineux en transmission lié à la mise en oeuvre de l'élément en couches 3, en fonction de la texturation de sa surface externe 4A et de l'angle des rayons incidents. Les résultats sont exprimés en pourcentage (%) dans le tableau 2 ci-dessous.

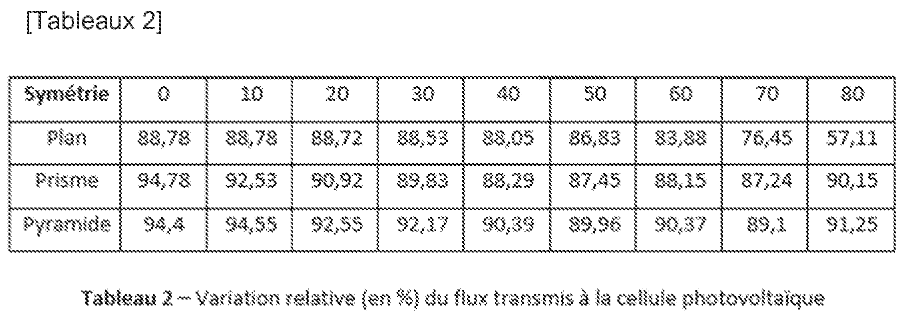

Ces résultats sont également illustrés par la figure 8. Il apparaît ainsi clairement que quel que soit l'angle d'incidence considéré, les surfaces externes 4A texturées offrent un gain lumineux plus important, et donc un meilleur rendement énergétique, que les surfaces externes lisses. Ceci est particulièrement évident lorsque l'angle d'incidence tend vers sa valeur maximale (80°), par rapport à la normale au plan théorique de texture.

Ces résultats permettent de plus d'établir que dans le contexte de motifs symétriques, les formes en pyramide inversée offrent de meilleures performances que les formes en prisme.

Afin d'évaluer l'influence du profil de texture de la surface externe 4A sur les performances de la cellule photovoltaïque 7, un quatrième essai est réalisé au moyen des dix échantillons suivants :
Un premier échantillon « réel » ayant une surface externe 4A lisse, qui sert de référence (dénominateur) pour le calcul du gain lumineux,
Un deuxième échantillon « idéal » présente une surface externe 4A texturée à motif symétrique « idéal » de forme pyramidale inversée à base carrée, de période 2 mm et d'angle au sommet d'environ 90° (soit la somme de deux demi-angles de 45°),
Un troisième échantillon « idéal » qui présente une surface externe 4A texturée à motif symétrique de forme prismatique, de période 2 mm et d'angle au sommet d'environ 90°,
Un quatrième échantillon « idéal » qui présente une surface externe 4A texturée à motif asymétrique en forme de demi-pyramide inversée, de période 1 mm et d'angle au sommet d'environ 45°,
Un cinquième échantillon « idéal » qui présente une surface externe 4A texturée à motif asymétrique en forme de demi-prisme, de période 1 mm et d'angle au sommet d'environ 45°,
Un sixième échantillon dit « réel » qui présente une surface externe 4A texturée à motif symétrique de forme prismatique, dont le sommet est la somme d'un demi-angle de 36,5° et d'un demi-angle de 34°,
Un septième échantillon dit « réel » qui présente une surface externe 4A texturée à motif asymétrique de forme prismatique, dont le sommet est la somme d'un grand angle de 45° et d'un petit angle de 15°,
Un huitième échantillon dit « réel » qui présente une surface externe 4A texturée à motif asymétrique de forme prismatique, dont le sommet est la somme d'un grand angle de 45° et d'un petit angle de 20°,
Un neuvième échantillon dit « réel » qui présente une surface externe 4A texturée à motif asymétrique de forme prismatique, dont le sommet est la somme d'un grand angle de 45° et d'un petit angle de 25°,
Un dixième échantillon dit « réel » qui présente une surface externe 4A texturée à motif asymétrique de forme prismatique, dont le sommet est la somme d'un grand angle de 45° et d'un petit angle de 30°,
Pour cet essai, les échantillons 2 à 5, dits « idéal », ont été simulés informatiquement car complexe à obtenir dans un contexte industriel. Au vu des procédés de texturation aujourd'hui mis en oeuvre, il est par exemple difficile d'obtenir un motif présentant un demi-angle de valeur nulle. Les simulations effectuées sur ces échantillons virtuels permettent de pousser à leurs limites les caractéristiques techniques étudiées et les effets techniques qui en résultent. En particulier, les conditions d'exposition à la lumière sont choisies de manière à reproduire le plus fidèlement possible les conditions habituelles d'ensoleillement d'une façade vitrée verticale.

Les échantillons 1 et 6 à 10, dits « réels », ont quant à eux été fabriqués à Mannheim (Allemagne) avant d'être mis en œuvre dans la ville de Cologne (Allemagne) sur des façades (parois verticales) orientées respectivement vers le nord, le sud, l'est et l'ouest. Les motifs prismatiques étaient alors orientés à l'horizontale. Des mesures portant sur le flux lumineux transmis à la cellule photovoltaïque ont alors été réalisées pendant une période d'exposition d'une année. Les valeurs de flux mesurées/simulées, une fois rapportées à la valeur de référence obtenue avec une surface lisse, permettent d'en déduire le gain lumineux en transmission lié à la mise en œuvre de ces motifs particuliers de texturation.

Dans le contexte du montage en façade des échantillons 4, 5 et 7 à 10, qui présentent tous une texture de surface externe à motif asymétrique, les motifs sont agencés de sorte que la face du motif asymétrique définie par le petit angle est sensiblement orientée vers le haut, tel qu'illustré par la figure 9. Une telle orientation permet de limiter les pertes en réflexion pouvant être liées à un piégeage défaillant des rayons incidents dans certaines conditions particulières d'éclairage.

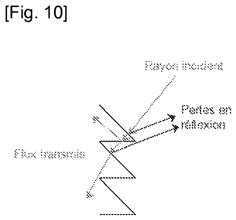

Afin d'illustrer ce phénomène, une telle orientation du motif asymétrique, illustrée par la figure 9, est comparée à une orientation opposée, illustrée par la figure 10, dans laquelle la face du motif définie par le petit angle est sensiblement orientée vers le bas. Le tracé (approximatif) des rayons solaires incidents, pour chacune de ces deux figures, permet d'illustrer les pertes lumineuses supplémentaires pouvant être occasionnées en réflexion, dans le cas d'une orientation vers le bas du petit angle (figure 10). Le corollaire de cette réflexion lumineuse accrue est que le flux transmis à la cellule photovoltaïque est réduit, ce qui nuit en conséquence au performances de la cellule photovoltaïque.

Les résultats obtenus par mesure et/ou simulation informatique sont exprimés en pourcentage (%) dans le tableau 3 ci-dessous.

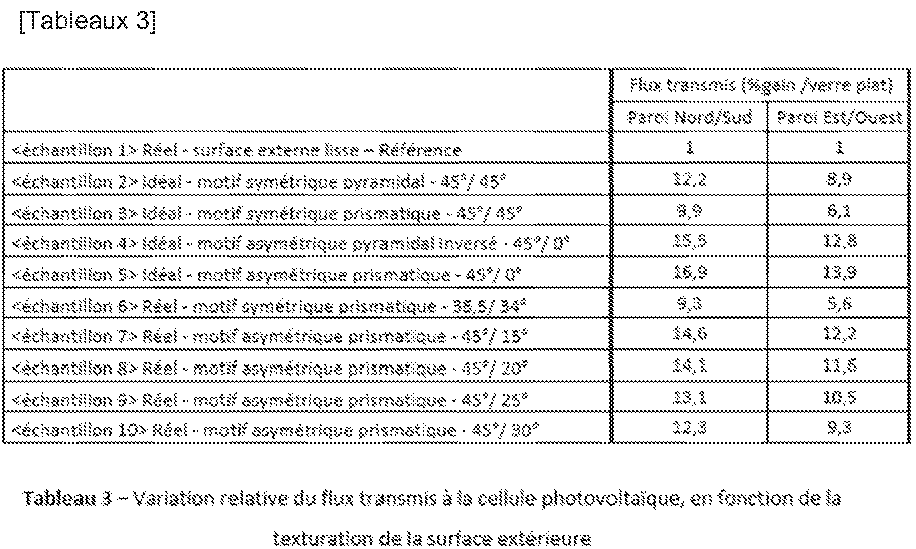

Les valeurs estimées sur échantillons « idéal » permettent d'aboutir à plusieurs conclusions :
- L'adoption de motifs asymétriques (échantillons 4 et 5) permet d'obtenir de bien meilleures performances en transmission lumineuse, en comparaison avec les texturations à motifs symétriques (échantillons 2 et 3). Dans le cas des motifs asymétriques en forme de prisme (échantillon 5), le gain en transmission est ainsi augmenté de 4,7% par rapport aux résultats obtenus sur la base de motifs symétriques prismatiques.
- Les motifs asymétriques en forme de prisme (échantillon 5) permettent d'obtenir de meilleures performances que les motifs asymétriques en forme de pyramide inverse (échantillon 4). La différence de gain est ainsi comprise entre 1 et 1 ,5%.
- Le gain théorique pouvant être obtenu avec des textures asymétriques dites « idéales » est très élevé, en étant compris entre 14 et 17%.

Les mesures réalisées sur échantillons « réel » permettent d'aboutir à plusieurs conclusions :
- Le gain lumineux en transmission augmente avec le caractère asymétrique du motif (échantillons 10 à 7).
- Tous les résultats obtenus via des textures asymétriques réelles sont meilleurs que ceux obtenus à partir de textures symétriques, même lorsque ces dernières sont simulées sur la base de valeurs « idéales ». Si une comparaison devait être faites entre des échantillons réels présentant d'une part une texture asymétrique, et d'autre part une texture symétrique, les différences de gain en transmission seraient encore plus importantes.

## Revendications

1. Installation photovoltaïque (8) adaptée pour être intégrée au bâtiment, et comprenant au moins une cellule photovoltaïque (7) en silicium, ladite installation photovoltaïque étant telle qu'elle comprend un élément en couches (1) transparent ou translucide, comprenant au moins une couche externe inférieure (2), destinée à être orientée vers l'intérieur du bâtiment, et une couche externe supérieure (4), destinée à être orientée vers l'extérieur du bâtiment, lesdites couches extérieures (2, 4) formant chacune une surface principale externe (2A, 4A) de l'élément en couches (1) et étant constituées en des matériaux diélectriques, ledit élément en couches (1) comprenant en outre un ensemble laminaire (3) intercalé entre les couches externes (2, 4) et formé d'au moins une couche intermédiaire (3K),
ladite couche intermédiaire (3K) étant soit une couche unique qui est une couche diélectrique d'indice de réfraction (n3) différent de celui des couches externes ou une couche métallique, soit un empilement de couches (31, 32, ..., 3k) qui comprend au moins une couche diélectrique d'indice de réfraction différent de celui des couches externes ou une couche métallique,
chaque surface de contact (S0, S1, ..., Sk) entre deux couches adjacentes de l'élément en couches qui sont l'une diélectrique et l'autre métallique, ou qui sont deux couches diélectriques d'indices de réfraction différents, étant texturée et préférentiellement parallèle aux autres surfaces de contact (S0, S1, ..., Sk),
ladite cellule photovoltaïque (7) étant soit agencée en-dessous, soit intégrée dans ladite couche externe inférieure (2),
**caractérisée en ce que** ladite couche externe inférieure (2) présente un indice de réfraction (n2) compris entre l'indice de réfraction (n4) de la couche externe supérieure (4) et l'indice de réfraction (n7) de la cellule photovoltaïque (7), l'indice de la cellule photovoltaïque étant celui du silicium, et satisfait la formule : n2 ≥ n4 + (n7 - n4)/3

2. Installation photovoltaïque (8) selon la revendication 1, **caractérisée en ce que** ledit élément en couches (1) présente, sur l'ensemble de la plage des longueurs d'onde comprise entre 300 nm et 1100 nm, une absorption lumineuse inférieure à 30%, préférentiellement inférieure à 25% préférentiellement inférieure à 20% , préférentiellement inférieure à 15% préférentiellement inférieure à 10%, préférentiellement inférieure à 5%, et/ou une réflexion inférieure à inférieure à 30%, préférentiellement inférieure à 25%, préférentiellement inférieure à 20%, préférentiellement inférieure à 10%, et supérieure à 2,5%, préférentiellement supérieur à 5%.

3. Installation photovoltaïque (8) selon les revendications 1 et 2, **caractérisée en ce que** ledit ensemble laminaire (3) est formé d'une pluralité de couches intermédiaires (31, 32, ..., 3K) et présente un réflexion au moins deux zones adjacentes (A, B, C, D) dont les couleurs sont distinctes l'une de l'autre.

4. Installation photovoltaïque (8) selon l'une des revendications 1 à 3, **caractérisée en ce qu'**au moins une couche intermédiaire (3K) est obtenue par pulvérisation cathodique assistée par champ magnétique (pulvérisation dite "cathodique magnétron") et/ou **en ce qu'**au moins une couche intermédiaire (3K) est obtenue par sérigraphie.

5. Installation photovoltaïque (8) selon l'une des revendications 1 à 4, **caractérisée en ce que** la couche externe supérieure (4) est destinée à être orientée vers l'extérieur du bâtiment, et comprend une surface externe (4A) texturée, dont la profondeur moyenne est préférentiellement supérieure à 0,8 mm, préférentiellement supérieure à 0,9 mm, préférentiellement supérieure à 1,0 mm, préférentiellement supérieure à 1,1 mm, préférentiellement supérieure à 1,2 mm, et préférentiellement inférieure à 1,5 mm, préférentiellement inférieure à 1,3 mm.

6. Installation photovoltaïque (8) selon la revendication 5, préférentiellement pour montage en toiture, **caractérisée en ce que** ladite surface externe (4A) texturée est à motif symétrique, par exemple de forme prismatique, préférentiellement de forme pyramidale inversée.

7. Installation photovoltaïque (8) selon la revendication 6, **caractérisée en ce que** la texture de ladite surface externe (4A) est à motif symétrique de forme pyramidale inversée d'angle au sommet compris entre 80 et 100°, et/ou dont le plus petit cercle théorique pouvant contenir la base des motifs présente un diamètre compris entre 1,0 à 5,0 mm, préférentiellement entre 1,5 et 4,0 mm, préférentiellement entre 2,0 et 3,5 mm, préférentiellement entre 2,4 et 3,0 mm.

8. Installation photovoltaïque (8) selon la revendication 5, préférentiellement pour montage en façade, **caractérisée en ce que** ladite surface externe (4A) texturée est à motif asymétrique, par exemple de forme pyramidale inversée, préférentiellement de forme prismatique.

9. Installation photovoltaïque (8) selon la revendication 8, **caractérisée en ce que** la texture de ladite surface externe (4A) est à motif asymétrique qui présente un grand angle au sommet, compris entre 20° et 70°, préférentiellement entre 30° et 60°, préférentiellement entre 35° et 55°, préférentiellement entre 40° et 50°, préférentiellement entre 43° et 47°, et/ou qui présente un petit angle inférieur à 30°, préférentiellement inférieur à 25°, préférentiellement inférieur à 20°, préférentiellement inférieur à 15°, préférentiellement inférieur à 10°, préférentiellement inférieur à 5°.

10. Installation photovoltaïque (8) selon l'une des revendications 1 à 9, **caractérisé en ce qu'**elle comprend au moins une couche antireflet (6), à l'interface entre la surface de ladite cellule photovoltaïque (7) destinée à être orientée vers l'extérieur du bâtiment et la couche externe inférieure (2), et/ou sur ladite surface externe (4A) de la couche externe supérieure (4).

11. Montage en bâtiment d'au moins une installation photovoltaïque (8) selon l'une des revendications 1 à 10.

12. Montage en bâtiment selon la revendication 11, **caractérisé en ce qu'**il est mis en oeuvre en toiture selon une orientation angulaire comprise entre 25 et 40°, préférentiellement entre 30 et 35° par rapport à l'horizontale, en direction du sud, préférentiellement au moyen d'une installation photovoltaïque (8) selon l'une des revendications 5 et 6.

13. Montage en bâtiment selon la revendication , **caractérisé en ce qu'**il est mis en oeuvre en façade, de préférence au niveau d'une allège, préférentiellement au moyen d'une installation photovoltaïque (8) selon la revendication 8 agencée de sorte que la face du motif asymétrique définie par ledit petit angle est sensiblement orientée vers le haut.

14. Procédé de fabrication d'une installation photovoltaïque (8) selon l'une des revendications 1 à 10, **caractérisé en ce qu'**il comprend soit l'agencement de la cellule photovoltaïque (7) en-dessous de l'élément en couches (1), soit son intégration au sein de la couche externe inférieure (2).

15. Utilisation d'une installation photovoltaïque (8) selon l'une des revendications 1 à 10, montée en bâtiment selon l'une des revendications 11 à 13, pour la production d'énergie électrique. 1

## Patentansprüche

1. Photovoltaikanlage (8), die angepasst ist, um in das Gebäude integriert zu werden, und umfassend mindestens eine Photovoltaikzelle (7) aus Silizium, wobei die Photovoltaikanlage derart beschaffen ist, dass sie ein transparentes oder durchscheinendes Schichtelement (1) umfasst, umfassend mindestens eine untere Außenschicht (2), die dafür bestimmt ist, zum Inneren des Gebäudes ausgerichtet zu sein, und eine obere Außenschicht (4), die dafür bestimmt ist, zum Äußeren des Gebäudes ausgerichtet zu sein, wobei die äußeren Schichten (2, 4) jeweils eine Außenhauptoberfläche (2A, 4A) des Schichtelements (1) ausbilden und aus dielektrischen Materialien bestehen, das Schichtelement (1) ferner umfassend eine laminare Anordnung (3), die zwischen den Außenschichten (2, 4) angeordnet und aus mindestens einer Zwischenschicht (3K) ausgebildet ist, wobei die Zwischenschicht (3K) entweder eine einzelne Schicht ist, die eine dielektrische Schicht mit einem Brechungsindex (n3), der sich von dem der Außenschichten unterscheidet, oder eine Metallschicht ist, oder ein Stapel von Schichten (31, 32, ..., 3k), der mindestens eine dielektrische Schicht mit einem Brechungsindex, der sich von dem der Außenschichten unterscheidet, oder eine Metallschicht ist, umfasst, wobei jede Kontaktoberfläche (S0, S1, ..., Sk) zwischen zwei Schichten, die an das Schichtelement angrenzen, von denen eine dielektrisch und die andere metallisch ist, oder die zwei dielektrische Schichten mit unterschiedlichen Brechungsindizes, texturiert und vorzugsweise parallel zu den anderen Kontaktoberflächen (S0, S1, ..., Sk) ist, wobei die Photovoltaikzelle (7) entweder unterhalb angeordnet oder in die untere Außenschicht integriert ist,
**dadurch gekennzeichnet, dass** die untere Außenschicht (2) einen Brechungsindex (n2), der zwischen dem Brechungsindex (n4) der oberen Außenschicht (4) und dem Brechungsindex (n7) der Photovoltaikzelle (7) liegt, aufweist, wobei der Index der Photovoltaikzelle der von Silizium ist, und die Formel: n2 ≥ n4 + (n7 - n4)/3 erfüllt

2. Photovoltaikanlage (8) nach Anspruch 1, **dadurch gekennzeichnet, dass** das Schichtelement (1) über den gesamten Wellenlängenbereich zwischen 300 nm und 1100 nm eine Lichtabsorption aufweist von: weniger als 30 %, vorzugsweise weniger als 25 %, vorzugsweise weniger als 20 %, vorzugsweise weniger als 15 %, vorzugsweise weniger als 10 %, vorzugsweise weniger als 5 %, und/oder
größer als 2,5 %, vorzugsweise größer als 5 %.

3. Photovoltaikanlage (8) nach Anspruch 1 und 2,
**dadurch gekennzeichnet, dass** die laminare Anordnung (3) aus einer Vielzahl von Zwischenschichten (31, 32, ..., 3K) ausgebildet ist und eine Reflexion von mindestens zwei angrenzenden Bereichen (A, B, C, D), deren Farben sich voneinander unterscheiden, aufweist.

4. Photovoltaikanlage (8) nach einem der Ansprüche 1 bis 3,
**dadurch gekennzeichnet, dass** mindestens eine Zwischenschicht (3K) durch magnetfeldunterstützte Kathodenzerstäubung (als "Magnetronkathodenzerstäubung" bezeichnet) erhalten wird und/oder dass mindestens eine Zwischenschicht (3K) durch Siebdruck hergestellt ist.

5. Photovoltaikanlage (8) nach einem der Ansprüche 1 bis 4,
**dadurch gekennzeichnet, dass** die obere Außenschicht (4) dafür bestimmt ist, 0,8 mm, vorzugsweise über dem Äußeren des Gebäudes, ausgerichtet zu sein, und eine texturierte Außenoberfläche (4A) umfasst, deren durchschnittliche Tiefe vorzugsweise größer als 0,8 mm, vorzugsweise größer als 0,9 mm, vorzugsweise größer als 1,0 mm, vorzugsweise größer als 1,1 mm, vorzugsweise größer als 1,2 mm und vorzugsweise kleiner als 1,5 mm, vorzugsweise kleiner als 1,3 mm, ist.

6. Photovoltaikanlage (8) nach Anspruch 5, vorzugsweise für eine Dachmontage, **dadurch gekennzeichnet, dass** die texturierte Außenoberfläche (4A) ein symmetrisches Muster, zum Beispiel eine prismatische Form, vorzugsweise eine umgekehrte Pyramidenform, besitzt.

7. Photovoltaikanlage (8) nach Anspruch 6, **dadurch gekennzeichnet, dass** die Textur der Außenoberfläche (4A) ein symmetrisches Muster in einer umgekehrten Pyramidenform mit einem Scheitelwinkel zwischen 80 und 100° besitzt und/oder deren kleinster theoretischer Kreis, der die Basis der Muster enthalten kann, einen Durchmesser zwischen 1,0 und 5,0 mm, vorzugsweise zwischen 1,5 und 4,0 mm, vorzugsweise zwischen 2,0 und 3,5 mm, vorzugsweise zwischen 2,4 und 3,0 mm, aufweist.

8. Photovoltaikanlage (8) nach Anspruch 5, vorzugsweise für eine Fassadenmontage, **dadurch gekennzeichnet, dass** die texturierte Außenoberfläche (4A) ein asymmetrisches Muster, zum Beispiel eine umgekehrte Pyramidenform, vorzugsweise eine prismatische Form, besitzt.

9. Photovoltaikanlage (8) nach Anspruch 8, **dadurch gekennzeichnet, dass** die Textur der Außenoberfläche (4A) ein asymmetrisches Muster besitzt, das einen großen Winkel an der Spitze aufweist, der zwischen 20° und 70°, vorzugsweise zwischen 30° und 60°, vorzugsweise zwischen 35° und 55°, vorzugsweise zwischen 40° und 50°, vorzugsweise zwischen 43° und 47°, liegt, und/oder der einen kleinen Winkel von kleiner als 30°, vorzugsweise kleiner als 25°, vorzugsweise kleiner als 20°, vorzugsweise kleiner als 15°, vorzugsweise kleiner als 10°, vorzugsweise kleiner als 5°, aufweist.

10. Photovoltaikanlage (8) nach einem der Ansprüche 1 bis 9,
**dadurch gekennzeichnet, dass** sie mindestens eine Antireflexionsschicht (6) an der Schnittstelle zwischen der Oberfläche der Photovoltaikzelle (7), die dafür bestimmt ist, zum Äußeren des Gebäudes ausgerichtet zu sein, und der unteren Außenschicht (2) und/oder an der Außenoberfläche (4A) der oberen Außenschicht (4) umfasst.

11. Gebäudemontage mindestens einer Photovoltaikanlage (8) nach einem der Ansprüche 1 bis 10.

12. Gebäudemontage nach Anspruch 11, **dadurch gekennzeichnet, dass** sie auf dem Dach in einer Winkelausrichtung zwischen 25 und 40°, vorzugsweise zwischen 30 und 35° relativ zu der Horizontalen, in Richtung Süden, umgesetzt wird, vorzugsweise mithilfe einer Photovoltaikanlage (8) nach einem der Ansprüche 5 und 6.

13. Gebäudemontage nach Anspruch 11, **dadurch gekennzeichnet, dass** sie an der Fassade, vorzugsweise an einer Brüstung, umgesetzt wird, vorzugsweise mithilfe einer Photovoltaikanlage (8) nach Anspruch 8, die angeordnet ist, sodass die durch den kleinen Winkel definierte Seite des asymmetrischen Musters im Wesentlichen nach oben ausgerichtet ist.

14. Verfahren zum Herstellen einer Photovoltaikanlage (8) nach einem der Ansprüche 1 bis 10, **dadurch gekennzeichnet, dass** es entweder das Anordnen der Photovoltaikzelle (7) unterhalb des Schichtelements (1) oder ihr Integrieren innerhalb der unteren Außenschicht (2) umfasst.

15. Verwendung einer Photovoltaikanlage (8) nach einem der Ansprüche 1 bis 10, die nach einem der Ansprüche 11 bis 13 an einem Gebäude für die Erzeugung von elektrischer Energie montiert ist.

## Claims

1. Photovoltaic installation (8) which is suitable for being integrated into the building and comprises at least one photovoltaic cell (7) made of silicon, the photovoltaic installation being such that it comprises a transparent or translucent layered element (1) comprising at least one lower outer layer (2) which is intended to be oriented toward the interior of the building, and an upper outer layer (4) which is intended to be oriented toward the outside of the building, the outer layers (2, 4) each forming an outer main surface (2A, 4A) of the layered element (1) and consisting of dielectric materials, the layered element (1) further comprising a laminar assembly (3) which is inserted between the outer layers (2, 4) and is formed from at least one intermediate layer (3K), the intermediate layer (3K) being either a single layer which is a dielectric layer having a refractive index (n3) which is different from that of the outer layers or a metal layer, or a stack of layers (31, 32, ..., 3k) which comprises at least one dielectric layer having a refractive index which is different from that of the outer layers or a metal layer, each contact surface (S0, S1, ..., Sk) between two adjacent layers of the layered element, of which one is dielectric and the other is metal or which are two dielectric layers having different refractive indexes, being textured and preferably parallel to the other contact surfaces (S0, S1, ..., Sk), the photovoltaic cell (7) either being arranged below or being integrated into the lower outer layer (2),
**characterized in that** the lower outer layer (2) has a refractive index (n2) which is between the refractive index (n4) of the upper outer layer (4) and the refractive index (n7) of the photovoltaic cell (7), the index of the photovoltaic cell being that of silicon, and satisfies the formula: n2 ≥ n4 + (n7 - n4)/3

2. Photovoltaic installation (8) according to claim 1, **characterized in that** the layered element (1) has, over the entire wavelength range of between 300 nm and 1100 nm, a light absorption of less than 30%, preferably less than 25%, preferably less than 20%, preferably less than 15%, preferably less than 10%, and preferably less than 5%, and/or
a reflection of less than less than 30%, preferably less than 25%, preferably less than 20%, and preferably less than 10%, and
greater than 2.5%, preferably greater than 5%.

3. The photovoltaic installation (8) according to either claim 1 or claim 2, **characterized in that** the laminar assembly (3) is formed from a plurality of intermediate layers (31, 32, .., 3K) and has a reflection at least two adjacent regions (A, B, C, D) of which the colors are distinct from one another.

4. The photovoltaic installation (8) according to any of claims 1 to 3, **characterized in that** at least one intermediate layer (3K) is obtained by magnetic field-assisted cathode sputtering ("magnetron cathode sputtering") and/or **in that** at least one intermediate layer (3K) is obtained by screen printing.

5. The photovoltaic installation (8) according to any of claims 1 to 4, **characterized in that** the upper outer layer (4) is intended to be oriented toward 0.8 mm, preferably greater than the outside of the building, and comprises a textured outer surface (4A), the average depth of which is preferably greater than 0.8 mm, preferably greater than 0.9 mm, preferably greater than 1.0 mm, preferably greater than 1.1 mm, preferably greater than 1.2 mm, preferably less than 1.5 mm, and preferably less than 1.3 mm.

6. The photovoltaic installation (8) according to claim 5, preferably mounting on a roof, **characterized in that** the textured outer surface (4A) has a symmetrical design, for example a prismatic shape, preferably an inverted pyramidal shape.

7. Photovoltaic installation (8) according to claim 6, **characterized in that** the texture of the outer surface (4A) has a symmetrical design of an inverted pyramidal shape which has an apex angle of between 80 and 100°, and/or of which the smallest theoretical circle which can contain the base of the patterns has a diameter of between 1.0 to 5.0 mm, preferably between 1.5 and 4.0 mm, preferably between 2.0 and 3.5 mm, and preferably between 2.4 and 3.0 mm.

8. The photovoltaic installation (8) according to claim 5, preferably for mounting on a facade, **characterized in that** the textured outer surface (4A) has an asymmetrical design, for example an inverted pyramidal shape, preferably a prismatic shape.

9. The photovoltaic installation (8) according to claim 8, **characterized in that** the texture of the outer surface (4A) has an asymmetrical design which has a large apex angle of between 20° and 70°, preferably between 30° and 60°, preferably between 35° and 55°, preferably between 40° and 50°, and preferably between 43° and 47°, and/or which has a small angle of less than 30°, preferably less than 25°, preferably less than 20°, preferably less than 15°, preferably less than 10°, and preferably less than 5°.

10. Photovoltaic installation (8) according to any of claims 1 to 9,
**characterized in that** it comprises at least one anti-reflective layer (6) at the interface between the surface of the photovoltaic cell (7) which is intended to be oriented toward the outside of the building and the lower outer layer (2), and/or on the outer surface (4A) of the upper outer layer (4).

11. Mounting at least one photovoltaic installation (8) according to any of claims 1 to 10 in a building.

12. Mounting in a building according to claim 11, **characterized in that** it is carried out on a roof according to an angular orientation of between 25 and 40°, preferably between 30 and 35°, with respect to the horizontal in the direction of the south, preferably using a photovoltaic installation (8) according to either claim 5 or claim 6.

13. Mounting in a building according to claim 11, **characterized in that** it is carried out on a facade, preferably at the level of a spandrel, preferably using a photovoltaic installation (8) according to claim 8 which is arranged so that the face of the asymmetric design, which is defined by the small angle, is substantially oriented upward.

14. Method for manufacturing a photovoltaic installation (8) according to any of claims 1 to 10, **characterized in that** it comprises either arranging the photovoltaic cell (7) below the layered element (1), or integrating it within the lower outer layer (2).

15. Use of a photovoltaic installation (8) according to any of claims 1 to 10 which is mounted in a building according to any of claims 11 to 13 in order to produce electrical energy.
